# EUROPÄISCHE PATENTSCHRIFT

(11) **EP 1 191 598 B1**
(45) Veröffentlichungstag und Bekanntmachung des Hinweises auf die Patenterteilung: **19.12.2007**
(21) Anmeldenummer: 00810853.2
(22) Anmeldetag: 20.09.2000
(51) Int. Cl.: H01L 29/06, H01L 31/103, H01L 29/861, H01L 21/329

(54) **Verfahren zur Herstellung eines Halbleiter-Photosensors**
Method for fabricating a semiconductor photosensor
Procédé de fabrication d'un photodétecteur à semiconducteur

(43) Veröffentlichungstag der Anmeldung: 27.03.2002
(73) Patentinhaber: Siemens Schweiz AG, 8047 Zürich (CH)
(72) Erfinder: Popovic, Radivoje, 6300 Zug (CH); Pauchard, Alexandre, 1624 Progens (CH); Rochas, Alexis, 1018 Lausanne (CH)
(74) Vertreter: Weise, Wolfgang

(56) Entgegenhaltungen:
- EP-A- 0 296 371
- EP-A- 0 948 038
- DE-A- 4 329 837
- US-A- 3 735 210
- US-A- 4 127 859
- US-A- 4 683 483
- US-A- 5 298 788
- PATENT ABSTRACTS OF JAPAN vol. 006, no. 218 (E-139), 2. November 1982 (1982-11-02) & JP 57 122579 A (MITSUBISHI DENKI KK), 30. Juli 1982 (1982-07-30)

## Beschreibung

Die Erfindung betrifft ein Verfahren zur Herstellung eines Halbleiter-Photosensors der im Oberbegriff des Anspruchs 1 genannten Art.

Halbleiterbauteile weisen eine Vielzahl von pn-Übergängen auf. Solche pn-Übergänge haben unter anderem vielfältige Anwendungen als Photosensoren gefunden.

Für die Überwachung von Brennern werden verschiedene Typen von Photosensoren eingesetzt. In den letzten zwanzig Jahren wurden konventionelle Gelblicht Brenner zunehmend ersetzt durch Blaulicht Brenner. Für die optische Detektion der An- oder Abwesenheit der Flamme eignet sich der ultraviolette Spektralbereich am besten, da die vom Brenner selbst stammende Infrarotstrahlung nicht zur Anzeige eines Signals "Flamme vorhanden" führen darf. Aus dem europäischen Patent EP 296 371 ist eine auf Silizium basierende Halbleiterdiode bekannt, die sich zur Überwachung von Blaulichtbrennern eignet. Bei gewissen Brennertypen ist das von der Flamme abgegebene Licht jedoch zu gering, um mit dieser Halbleiterdiode detektiert werden zu können. Bei diesen Brennern werden deshalb nach wie vor Photomultiplier oder Gasentladungsröhren eingesetzt. Diese Photosensoren sind gross, teuer, empfindlich auf magnetische Felder, können leicht beschädigt werden und benötigen zum Betrieb eine hohe Spannung.

Elektronische Kameras verwenden weitgehend Bildsensoren, die auf der CCD (charge-coupled devices) Technologie basieren. Im low-cost Bereich werden zunehmend auf der CMOS Technologie basierende Bildsensoren eingesetzt, bei denen jeder Pixel eine Photodiode, einen Vorverstärker und Ausleseelektronik enthält. Solche CMOS Bildsensoren sind zwar billiger, aber weniger empfindlich als CCD Bildsensoren.

Aus den Artikeln "CMOS compatible avalanche photodiode", Proceedings ofthe SPIE, 3410 (1998), Seiten 10 - 20, und "Avalanche photodiode array in BiCMOS technology" Proceedings of the SPIE, 3649 (1999) Seiten 40 - 49 von A. Biber und P. Seitz sind Avalanche Photodioden bekannt, die auf dem gleichen Chip wie die Elektronik hergestellt werden können. Solche Avalanche Photodioden können gemäss der Doktorarbeit von W.J. Kindt mit dem Titel "Geiger mode avalanche photodiode arrays for spatially resolved single photon counting", Delft University Press, 1999, Kapitel 3 bis 6 im Geiger Modus betrieben werden und ermöglichen den Nachweis einzelner Photonen. Sie können gemäss der Doktorarbeit von A.Biber mit dem Titel "Avalanche Photodiode Image Sensing in Standard Silicon BiCMOS Technology", Diss ETH Nr. 13544, Kapitel 5, auch als Bildsensor verwendet werden. Eine Avalanche Photodiode, die im ultravioletten Spektralbereich empfindlich ist, ist bekannt aus A. Pauchard's Doktorarbeit mit dem Titel "Silicon Sensor Microsystem for Ultraviolet Detection", Hartung-Gorre Series in Microsystems Volume 7 (2000), Kapitel 4 und 5. Diese bekannten Avalanche Photodioden benötigen jedoch spezielle Prozessschritte und weisen zudem zu hohe Leckströme auf.

Ein Verfahren zur Herstellung einer Zeuerdiode ist aus US-A-4,127,859 bekannt.

Der Erfindung liegt die Aufgabe zugrunde, Halbleiter-Photosensoren mit verbesserten Eigenschaften zu entwickeln, damit sie für die Flammenüberwachung und/oder für die Verwendung in elektronischen Kameras geeignet sind.

Die Erfindung besteht in den im Anspruch 1 angegebenen Merkmalen.

Der Beschreibung der Erfindung liegen die in der Herstellung von Halbleiterbauelementen geläufigen Begriffe zugrunde. Die Beschreibung beschränkt sich zudem auf die Darlegung der erfindungswesentlichen Merkmale.

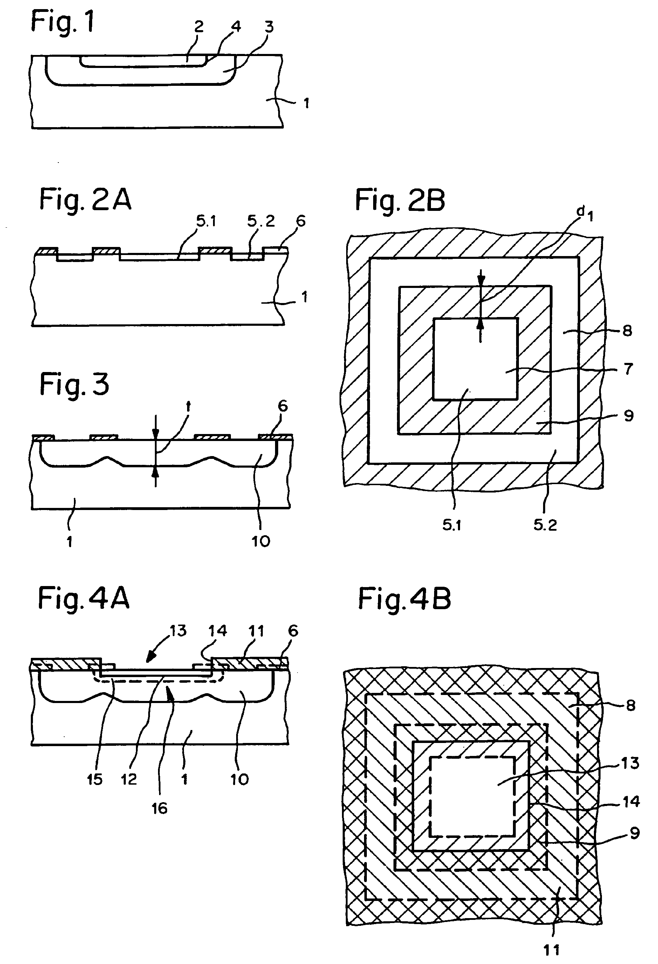

Die Fig. 1 zeigt im Querschnitt eine in CMOS Technologie realisierte Diode, die in ein p-dotiertes Substrat 1 eingebettet ist. Die Diode besteht aus einer p-Wanne 2, die sich vollständig innerhalb einer n-Wanne 3 befindet. Die Erfindung geht aus von der Erkenntnis, dass die Durchbruchspannung des zwischen den beiden Wannen 2 und 3 gebildeten pn-Übergangs durch Durchbrüche entlang des seitlichen Randes 4 des pn-Überganges begrenzt wird. Der Grund dafür ist, dass die Konzentration der Ionen der n-Wanne 3 an diesen Stellen am grössten ist und dass an der Stelle 4 eine Felderhöhung (sogenannter Spitzeneffekt) auftritt.

Erfindungsgemäss wird nun vorgeschlagen, die Konzentration der Ionen im kritischen Bereich des p-n Überganges zu verkleinern, indem bei der Implantation zur Bildung der n-Wanne 3 eine Maske verwendet wird, die einen Teil der späteren n-Wanne 3 abdeckt, nämlich den Teil, in dem der Rand der p-Wanne 2 zu liegen kommt. Weil die n-Wanne 3 ohmisch kontaktiert werden muss, werden bei der Implantation der n-Wanne 3 zunächst zwei n-dotierte Gebiete erzeugt, deren Abstand aber so bemessen ist, dass sich die beiden getrennten Gebiete bei den nachfolgenden Diffusionen zu einem einzigen Gebiet vereinigen. Auf diese Weise lässt sich die Konzentration der Ionen der n-Wanne 3 im Bereich des seitlichen Randes der p-Wanne 2 markant reduzieren und somit die Durchbruchspannung des pn-Überganges erhöhen.

Die Erfindung ermöglicht auch die Herstellung von MOS Transistoren mit verbesserten Eigenschaften.

Nachfolgend werden Ausführungsbeispiele der Erfindung anhand der Zeichnung näher erläutert.

Es zeigen:
- Fig. 1: den pn-Übergang einer konventionellen Diode,
- Fig. 2 - 4: verschiedene Schritte bei der Herstellung eines erfindungsgemässen Photosensors,
- Fig. 5: das Layout der Masken für die Herstellung eines weiteren erfindungsgemässen Photosensors, und
- Fig. 6, 7: einen p-Kanal MOS Transistor.

Die Fig. 2A zeigt im Querschnitt ein Substrat 1 eines ersten Leitfähigkeitstyps, in dessen Oberfläche durch Implantation zwei getrennte Gebiete 5.1 und 5.2 eines zweiten Leitfähigkeitstyps gebildet worden sind. Bei der Implantation deckt eine Maske 6 diejenigen Gebiete ab, die nicht zu dotieren sind. Wenn ein p-dotiertes Substrat 1 verwendet wird, dann ist der erste Leitfähigkeitstyp p-leitend und der zweite Leitfähigkeitstyp n-leitend. Wenn ein n-dotiertes Substrat 1 verwendet wird, dann ist der erste Leitfähigkeitstyp n-leitend und der zweite Leitfähigkeitstyp p-leitend.

Die Fig. 2B zeigt die Maske 6 in der Aufsicht. Die Maske 6 weist zwei Öffnungen, nämlich ein zentrales Fenster 7 und einen umlaufenden Streifen 8 auf, die durch einen abdeckenden Streifen 9 getrennt sind, so dass bei der Implantation zunächst die beiden getrennten Gebiete 5.1 und 5.2 des zweiten Leitfähigkeitstyps entstehen. Die Breite d₁ des abdeckenden Streifens 9 ist so bemessen, dass sich die beiden getrennten Gebiete 5.1 und 5.2 des zweiten Leitfähigkeitstyps bei dem oder den nachfolgenden Diffusionsprozessen infolge der seitlichen Diffusion zu einer einzigen Wanne 10 des zweiten Leitfähigkeitstyps vereinigen. Dieser Zustand ist in der Fig. 3 dargestellt. Typischerweise ist die Breite d₁ des abdeckenden Streifens 9 der Maske 6 etwa so gross wie die Tiefe t der Wanne 10.

Die Fig. 4A zeigt die Maske 11, die bei der Implantation eines Gebietes 12 des ersten Leitfähigkeitstyps, das vollständig innerhalb der Wanne 10 liegt, verwendet wird. Mit gestrichelter Linie eingezeichnet ist auch die Lage der Maske 6, die für die Herstellung der Wanne 10 benutzt wurde. Die Maske 11 weist ein Fenster 13 auf, dessen Rand 14 annähernd in der Mitte des abdeckenden Streifens 9 der Maske 6 liegt. Die Maske 11 deckt also das durch die Maske 6 definierte Gebiet 5.2 vollständig ab. Das Gebiet 12 überlappt das durch die Maske 6 definierte Gebiet 5.1 vollständig und ist grösser als das Gebiet 5.1. Das Gebiet 12 berührt aber das Gebiet 5.2 nicht.

Die Fig. 4B zeigt die Maske 11 in der Aufsicht. Die Lage der Maske 6, die für die Herstellung der Wanne 10 benutzt wurde, ist wiederum mit gestrichelter Linie eingezeichnet. Nach der Implantation findet ein Diffusionsprozess statt, der vor allem der elektrischen Aktivierung der implantierten Ionen dient. Das Gebiet 12 bildet nun eine Wanne 15 des ersten Leitfähigkeitstyps. Die beiden Wannen 10 und 15 bilden einen pn-Übergang. Im Bereich des seitlichen Randes 4 ist die Konzentration der Ionen der Wanne 10 nun geringer als bei einem herkömmlichen pn-Übergang, so dass eine höhere Durchbruchspannung resultiert. Bei sorgfältiger Alignierung der beiden Masken 6 und 11, die zur Bildung der Wanne 10 bzw. der Wanne 15 verwendet werden, und richtiger Wahl der Breite d₁ des abdeckenden Streifens 9 (Fig. 2B) ergibt sich ein pn-Übergang, bei dem der Durchbruch nun nicht mehr entlang des seitlichen Randes 4, sondern im zentralen, flachen Bereich 16 des pn-Überganges erfolgt. Ein derart hergestellter pn-Übergang eignet sich zum Betrieb als Diode mit erhöhter Durchbruchspannung oder zum Betrieb als Avalanche Photodiode mit verbesserter Lichtempfindlichkeit.

Das zweite Gebiet 5.2 dient auch der ohmischen Kontaktierung der Wanne 10, wozu mindestens ein Teil des zweiten Gebietes 5.2 mit einem weiteren Implantationsprozess stark dotiert wird. Es hängt nun von den bei der Alignierung der Masken 6 und 11 erreichbaren Toleranzen ab, ob das zweite Gebiet 5.2 als umlaufender Streifen 8 auszubilden ist. Das Fenster 13 in der Maske 11 ist dann jedenfalls grösser als das Gebiet 5.1, aber kleiner als die diffundierte Wanne 10. Bei Photosensoren bietet ein hochdotierter umlaufender Streifen 8 aber den Vorteil eines minimalen Innenwiderstandes.

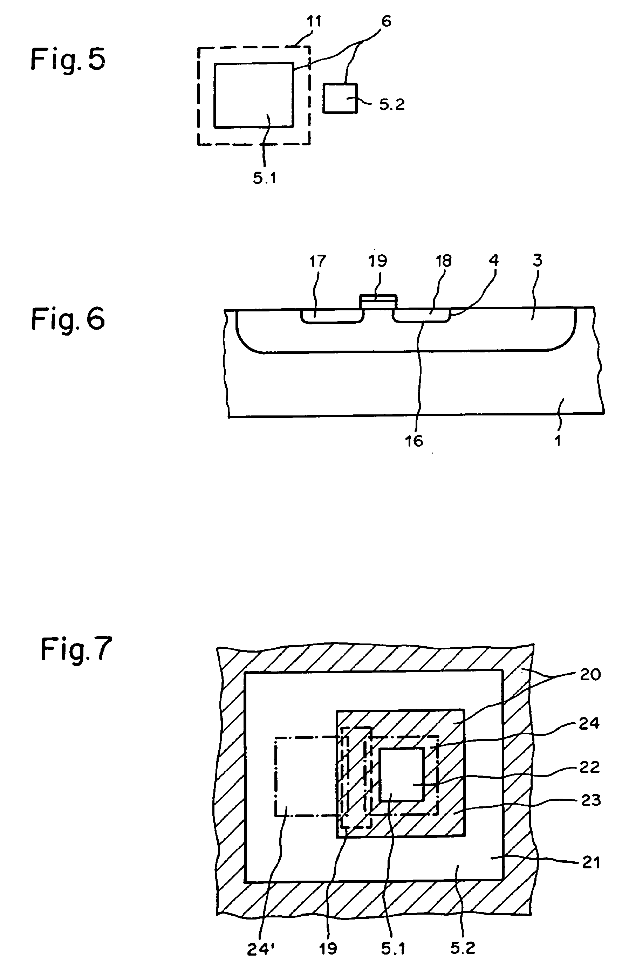

Die Fig. 5 zeigt das Layout der Maske 6 für die Herstellung der Wanne 10 des zweiten Leitfähigkeitstyps und der Maske 11 der Wanne 15 des ersten Leitfähigkeitstyps für eine Anordnung, wo das zweite Gebiet 5.2 nur so gross ist, dass die elektrische Kontaktierung der Wanne 10 einwandfrei erfolgen kann.

Die Fig. 6 zeigt im Querschnitt einen p-Kanal MOS Transistor, der eine in ein p-dotiertes Substrat 1 diffundierte n-Wanne 3, zwei als Source 17 bzw. Drain 18 dienende p++ dotierte Gebiete und ein Gate 19 aufweist. Um eine höhere Durchbruchspannung des pn-Überganges zwischen dem Drain 18 und der n-Wanne 3 zu erreichen, wird bei der n-Wannen Implantation eine Maske 20 verwendet, bei der ein Teil des beim Stand der Technik an sich üblichen, rechteckförmigen Fensters abgedeckt war. Die Maske 20 für die n-Wanne 3 enthält also, wie in der Fig. 7 dargestellt ist, nicht ein einziges Fenster 21, sondern zwei Fenster 21 und 22, die durch ein streifenförmiges Gebiet 23 getrennt sind. Während des der n-Wannen Implantation folgenden Diffusionsprozesses bleiben die beiden n-dotierten Gebiete 5.1 und 5.2 nun aber nicht getrennt, sondern infolge der auch seitwärts verlaufenden Diffusion vereinigen sich die beiden n-dotierten Gebiete 5.1 und 5.2 zur n-Wanne 3 (Fig. 6).

Die Maske für die Implantation des Drain 18 weist ein mit strichpunktierter Umrandung dargestelltes Fenster 24 auf, das grösser als das Fenster 22 ist, so dass sein Rand innerhalb des streifenförmigen Gebietes 23 liegt, wo die Konzentration der Ionen der n-Wanne 3 gegenüber den aus dem Stand der Technik bekannten MOS Transistoren reduziert ist. Mit strichpunktierter Linie ist auch das Fenster 24' des Source dargestellt. Die Durchbruchspannung zwischen Drain 18 und n-Wanne 3 wird daher analog zum oben erläuterten Beispiel der Diode nicht mehr durch Durchbrüche im Bereich des seitlichen Randes 4 (Fig. 6) des Drain 18 begrenzt, sondern durch Durchbrüche im zentralen, flachen Bereich 16.

Auch die Schwellspannung des MOS Transistors kann verkleinert werden, wenn das Gate 19 vollständig über dem streifenförmigen Gebiet 23 angeordnet ist, da dort die Dotierung der n-Wanne 3 reduziert ist.

Die beschriebenen pn-Übergänge lassen sich beispielsweise in der bekannten CMOS Technologie einsetzen. Auf diese Weise können hochempfindliche Photosensoren mit der zugehörigen Signalverarbeitungsschaltung auf einem einzigen Halbleiterchip realisert werden. Solche Photosensoren können zusätzlich mit einem optischen, an den Spektralbereich der Flamme angepassten Antireflexionsfilter in der Flammenüberwachung eingesetzt oder als CMOS kompatible Photosensoren zu einem zweidimensionalen Bildsensor erweitert werden. Für Dimensionierungsbeispiele für die Dotierungen für UV Photosensoren wird ausdrücklich auf das eingangs zitierte Patent EP 296 371 verwiesen.

## Patentansprüche

1. Verfahren zur Herstellung eines Halbleiter-Photosensors, wobei
- innerhalb eines Gebietes (1) eines ersten Leitfähigkeitstyps durch Implantation ein erstes und ein zweites Gebiet (5.1, 5.2) eines zweiten Leitfähigkeitstyps gebildet werden, die zunächst voneinander getrennt sind,
- sich das erste und das zweite Gebiet (5.1, 5.2) bei nachfolgenden Diffusionsprozessen infolge seitlicher Diffusion zu einer zusammenhängenden Wanne (10) vereinigen,
- durch Implantation ein weiteres Gebiet (12) des ersten Leitfähigkeitstyps gebildet wird, das das erste Gebiet (5.1) des zweiten Leitfähigkeitstyps vollständig überlappt und das grösser ist als das erste Gebiet (5.1), und das das zweite Gebiet (5.2) des zweiten Leitfähigkeitstyps nicht berührt.

## Claims

1. Method for fabricating a semiconductor photosensor, wherein
- a first and a second region (5.1, 5.2) of a second conductivity type which are initially isolated from each other are formed within one region (1) of a first semiconductor type by means of implantation,
- the first and the second region (5.1, 5.2) are merged into a contiguous well (10) in subsequent diffusion processes as a consequence of lateral diffusion,
- a further region (12) of the first conductivity type is formed by implantation, said region completely overlapping the first region (5.1) of the second conductivity type and being larger than the first region (5.1), and said region (12) not contacting the second region (5.2) of the second conductivity type.

## Revendications

1. Procédé de fabrication d'un photodétecteur à semi-conducteur,
- un premier et un deuxième domaines (5.1, 5.2) d'un deuxième type de conductibilité, qui sont d'abord séparés, étant formés, par implantation, dans un domaine (1) d'un premier type de conductibilité,
- le premier et le deuxième domaines (5.1, 5.2) se réunissant lors de processus subséquents de diffusion suite à une diffusion latérale en un puits communicant (10),
- un domaine supplémentaire (12) du premier type de conductibilité étant formé par implantation, qui recouvre complètement le premier domaine (5.1) du deuxième type de conductibilité et qui est plus grand que le premier domaine (5.1) et ne touche pas le deuxième domaine (5.2) du deuxième type de conductibilité.
